# EUROPEAN PATENT APPLICATION

(11) **EP 4 542 661 A1**
(43) Date of publication of application: **23.04.2025**
(21) Application number: 23892989.7
(22) Date of filing: 21.04.2023
(51) Int. Cl.: H01L 33/36, H01L 33/20, H01L 33/14, H01L 33/06

(54) **DEEP ULTRAVIOLET (UV) LIGHT-EMITTING DIODE (LED)**

(30) Priority: 24.11.2022 CN 202211480758
(71) Applicant: Suzhou Uvcantek Co., Ltd, Suzhou, Jiangsu 215000 (CN)
(72) Inventor: ZHANG, Jun, Suzhou, Jiangsu 215200 (CN); ZHANG, Yi, Suzhou, Jiangsu 215200 (CN); YUE, Jinshun, Suzhou, Jiangsu 215200 (CN)
(74) Representative: Ipside
(86) International application number: PCT/CN2023/089823
(87) International publication number: WO 2024/108888

(57) **Abstract**

The present invention provides a deep ultraviolet light-emitting diode, comprising a substrate, an intrinsic layer, an electron injection layer, an N-type ohmic contact layer, a current spreading layer, a quantum well active layer, an electron blocking layer, a hole injection layer, a P-type ohmic contact layer, and a P-type electrode stacked from bottom to top. The deep ultraviolet light-emitting diode also includes an N-type electrode. A step structure is formed between the current spreading layer and the N-type ohmic contact layer, with the N-type electrode placed at the step structure of the N-type ohmic contact layer. The deep ultraviolet light-emitting diode further includes an improvement layer disposed between the N-type ohmic contact layer and the N-type electrode. The material of the improvement layer includes at least one of GaN, InN, AIN, AlGaN, InGaN, and AllnGaN. The aforementioned deep ultraviolet light-emitting diode forms a good ohmic contact between the N-type electrode and the electron injection layer, thereby reducing the operating voltage of the deep ultraviolet light-emitting diode and improving the luminous performance of the epitaxial structure of the deep ultraviolet light-emitting diode.

## Description

### Technical Field

The present invention relates to the field of semiconductor optoelectronics, particularly to a deep ultraviolet light-emitting diode.

### Background Technology

Currently, in the ultraviolet spectrum, light with wavelengths between 200 nanometers and 350 nanometers is referred to as deep ultraviolet light. Deep ultraviolet light-emitting diodes, due to their advantages of high efficiency, environmental friendliness, energy-saving, and reliability, have significant application value in fields such as lighting, sterilization, medical treatment, printing, biochemical detection, high-density information storage, and secure communications. These advantages are unmatched by ordinary ultraviolet light-emitting diodes.

However, deep ultraviolet light-emitting diodes currently face several issues affecting voltage, light extraction efficiency, or emission uniformity: First, in the epitaxial structure of deep ultraviolet light-emitting diodes, the bottom layer is usually composed of high Al-content AlGaN. As the Al content in AlGaN increases, Si doping and activation become more difficult, often making it challenging to form a good ohmic contact with the contact electrode, thereby affecting the luminous performance of the deep ultraviolet light-emitting diode. Second, in deep ultraviolet light-emitting diodes, due to the significant difference in refractive indices between AlGaN material, sapphire, and air, most of the emitted light from the quantum well active region undergoes continuous internal reflection within the chip. When the direction of the emitted light points towards the N-type electrode, it is ultimately absorbed by the N-type electrode, affecting the external quantum efficiency of the deep ultraviolet light-emitting diode. Third, deep ultraviolet light-emitting diodes typically exhibit impurity light visible to the naked eye, and when the color of the impurity light is non-uniform, it can mislead users in judging the chip's performance. The emitted light from the quantum well active region, on one hand, excites the doped impurity energy levels in the hole injection layer to emit blue-violet light, and on the other hand, excites the doped impurity energy levels in the electron injection layer to emit yellow-green light. When the ratio between these two differs, the color of the impurity light varies.

Therefore, there is an urgent need for a deep ultraviolet light-emitting diode to solve the aforementioned technical problems.

### Summary of the Invention

The purpose of the present invention is to provide a deep ultraviolet light-emitting diode to address the technical problem of poor luminous performance in the epitaxial structure of existing deep ultraviolet light-emitting diodes.

To solve the above technical problem, the present invention provides a deep ultraviolet light-emitting diode, comprising a substrate, an intrinsic layer, an electron injection layer, an N-type ohmic contact layer, a current spreading layer, a quantum well active layer, an electron blocking layer, a hole injection layer, a P-type ohmic contact layer, and a P-type electrode stacked from bottom to top. The deep ultraviolet light-emitting diode also includes an N-type electrode. A step structure is formed between the current spreading layer and the N-type ohmic contact layer, with the N-type electrode placed at the step structure of the N-type ohmic contact layer;

The deep ultraviolet light-emitting diode also includes an improvement layer disposed between the N-type ohmic contact layer and the N-type electrode. The material of the improvement layer includes at least one of GaN, InN, AIN, AlGaN, InGaN, and AllnGaN.

In the deep ultraviolet light-emitting diode provided in this embodiment of the present invention, the thickness of the improvement layer ranges from 20nm to 10000nm; the aluminum composition content of the improvement layer is less than or equal to the aluminum composition content of the electron injection layer; the dopant of the improvement layer is Si, with a doping concentration range between 1E16cm-3 and 1E22cm-3.

In the deep ultraviolet light-emitting diode provided in this embodiment of the present invention, the improvement layer includes a first sub-improvement layer, the first sub-improvement layer comprising a single-layer structure formed of AlaInbGa1-a-bN material or a composite structure formed of AlₓIn_{y}Ga_{1-x-y}N/AlₘInₙGa₁₋ₘ₋ₙN material;

Where the values of a, b, x, m, y, and n are all greater than or equal to 0 and less than or equal to 100%.

In the deep ultraviolet light-emitting diode provided in this embodiment of the present invention, the first sub-improvement layer is any one of an N-type doped layer, a P-type doped layer, and an unintentionally doped layer;

Where, when the first sub-improvement layer is an N-type doped layer, the dopant is Si, with a doping concentration range between 1E19cm-3 and 1E22cm-3; when the first sub-improvement layer is a P-type doped layer, the dopant is Mg, with a doping concentration range between 1E18cm-3 and 1E23cm-3.

In the deep ultraviolet light-emitting diode provided in this embodiment of the present invention, the improvement layer includes a second sub-improvement layer, the second sub-improvement layer comprising a multi-layer stacked structure, each layer of the stacked structure including a first sublayer and a second sublayer stacked from bottom to top, the material of the first sublayer being AljGa1-jN, the material of the second sublayer being AlkGa1-kN, with the relationship between j and k satisfying 50%≤j≤k≤100%;

Where the thickness of the first sublayer is 0.25λ*n₁, the thickness of the second sublayer is 0.25λ*n₂, λ is the center wavelength of the light emitted by the quantum well active layer, n₁ is the average refractive index of the first sublayer, and n₂ is the average refractive index of the second sublayer.

In the deep ultraviolet light-emitting diode provided in this embodiment of the present invention, the second sub-improvement layer is any one of an N-type doped layer, a P-type doped layer, and an unintentionally doped layer;

Where, when the second sub-improvement layer is an N-type doped layer, the dopant is Si, with a doping concentration range between 1E19 cm⁻³ and 1E22cm⁻³; when the second sub-improvement layer is a P-type doped layer, the dopant is Mg, with a doping concentration range between 1E18cm⁻³ and 1E23cm⁻³.

In the deep ultraviolet light-emitting diode provided in this embodiment of the present invention, the improvement layer includes a third sub-improvement layer, the third sub-improvement layer comprising a single-layer structure formed of N-type doped AlGaN material;

Where the doping concentration of the third sub-improvement layer increases linearly from the side surface of the third sub-improvement layer closer to the substrate towards the side surface of the third sub-improvement layer farther from the substrate.

In the deep ultraviolet light-emitting diode provided in this embodiment of the present invention, the third sub-improvement layer is δ-type silicon-doped AlGaN material;
Where the number of δ-type silicon doping ranges from 1 to 50.

In the deep ultraviolet light-emitting diode provided in this embodiment of the present invention, the wavelength range of the first light emitted through the electron injection layer is between 500nm and 600nm, and the wavelength range of the second light emitted through the hole injection layer is between 400nm and 500nm;
Where the ratio of the first light to the second light ranges from 10% to 1000%.

In the deep ultraviolet light-emitting diode provided in this embodiment of the present invention, the improvement layer includes at least two of the first sub-improvement layer, the second sub-improvement layer, and the third sub-improvement layer;
Where the first sub-improvement layer comprises a single-layer structure formed of AlalnbGa1-a-bN material or a composite structure formed of AlₓIn_{y}Ga_{1-x-y}N/AlₘInₙGa₁₋ₘ₋ₙN material, with the values of a, b, x, m, y, and n all being greater than or equal to 0 and less than or equal to 100%;
The second sub-improvement layer includes a multi-layer stacked structure, each layer of the stacked structure including a first sublayer and a second sublayer stacked from bottom to top, the material of the first sublayer being AlⱼGa₁₋ⱼN, the material of the second sublayer being AlₖGa₁₋ₖN, with the relationship between j and k satisfying 50%≤j≤k≤100%;
where the thickness of the first sublayer is 0.25A*n₁, the thickness of the second sublayer is 0.25λ* n₂, λ is the center wavelength of the light emitted by the quantum well active layer, n₁ is the average refractive index of the first sublayer, and n₂ is the average refractive index of the second sublayer;
The third sub-improvement layer includes a single-layer structure formed of N-type doped AlGaN material, where the doping concentration of the third sub-improvement layer increases linearly from the side surface of the third sub-improvement layer closer to the substrate towards the side surface of the third sub-improvement layer farther from the substrate.

The beneficial effects of this invention are: Unlike existing technology, this invention provides a deep ultraviolet light-emitting diode, comprising a substrate, an intrinsic layer, an electron injection layer, an N-type ohmic contact layer, a current spreading layer, a quantum well active layer, an electron blocking layer, a hole injection layer, a P-type ohmic contact layer, and a P-type electrode stacked from bottom to top. The deep ultraviolet light-emitting diode also includes an N-type electrode. A step structure is formed between the current spreading layer and the N-type ohmic contact layer, with the N-type electrode placed at the step structure of the N-type ohmic contact layer. The deep ultraviolet light-emitting diode also includes an improvement layer disposed between the N-type ohmic contact layer and the N-type electrode. The material of the improvement layer includes at least one of GaN, InN, AIN, AlGaN, InGaN, and AllnGaN. The aforementioned deep ultraviolet light-emitting diode forms a good ohmic contact between the N-type electrode and the electron injection layer by epitaxially growing a special epitaxial structure as an improvement layer between the N-type ohmic contact layer and the N-type electrode, with the material of the improvement layer including at least one of GaN, InN, AIN, AlGaN, InGaN, and AllnGaN. This reduces the operating voltage of the deep ultraviolet light-emitting diode, thereby improving the luminous performance of the epitaxial structure of the deep ultraviolet light-emitting diode.

### Brief Description of the Drawings

Figure 1 is a first structural diagram of the deep ultraviolet light-emitting diode provided in the embodiment of the present invention;
Figure 2 is a second structural diagram of the deep ultraviolet light-emitting diode provided in the embodiment of the present invention;
Figure 3 is a third structural diagram of the deep ultraviolet light-emitting diode provided in the embodiment of the present invention;
Figure 4 is a process flow diagram of the epitaxial growth method for the deep ultraviolet light-emitting diode provided in the embodiment of the present invention.

### Detailed Description of the Embodiments

The following will describe the technical solutions in the embodiments of this invention clearly and completely in conjunction with the embodiments of this invention. Obviously, the described embodiments are only a part of the embodiments of this invention, not all of them. Based on the embodiments of this invention, all other embodiments obtained by those skilled in the art without creative efforts shall fall within the protection scope of this invention.

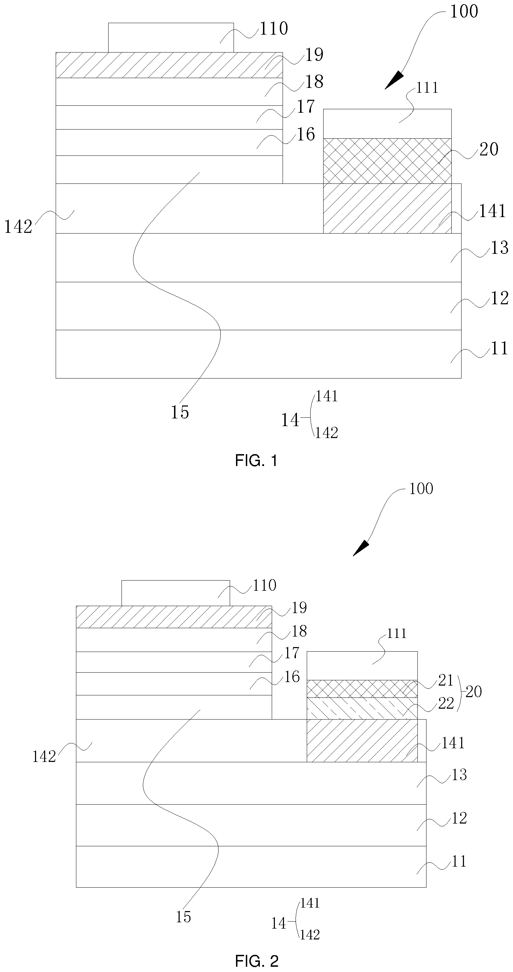

Please refer to Figures 1 to 3. The embodiment of this invention provides a deep ultraviolet light-emitting diode 100, comprising a substrate 11, an intrinsic layer 12, an electron injection layer 13, an N-type ohmic contact layer 14, a current spreading layer 15, a quantum well active layer 16, an electron blocking layer 17, a hole injection layer 18, a P-type ohmic contact layer 19, and a P-type electrode 110 stacked from bottom to top. The deep ultraviolet light-emitting diode 100 also includes an N-type electrode 111. A step structure is formed between the current spreading layer 15 and the N-type ohmic contact layer 14, with the N-type electrode 111 placed at the step structure of the N-type ohmic contact layer 14;
The deep ultraviolet light-emitting diode 100 also includes an improvement layer 20 disposed between the N-type ohmic contact layer 14 and the N-type electrode 111. The material of the improvement layer 20 includes at least one of GaN, InN, AIN, AlGaN, InGaN, and AlInGaN.

In this embodiment of the invention, by epitaxially growing a special epitaxial structure as an improvement layer 20 between the N-type ohmic contact layer 14 and the N-type electrode 111, with the material of the improvement layer 20 including at least one of GaN, InN, AIN, AlGaN, InGaN, and AlInGaN, a good ohmic contact is formed between the N-type electrode 111 and the electron injection layer 13. This reduces the operating voltage of the deep ultraviolet light-emitting diode 100, thereby improving the luminous performance of the epitaxial structure of the deep ultraviolet light-emitting diode 100.

Now, the technical solution of this application will be described in conjunction with specific embodiments.

### Embodiment 1

Please refer to Figure 1, which is the first structural diagram of the deep ultraviolet light-emitting diode 100 provided in the embodiment of this invention; The deep ultraviolet light-emitting diode 100 comprises a substrate 11, an intrinsic layer 12, an electron injection layer 13, an N-type ohmic contact layer 14, a current spreading layer 15, a quantum well active layer 16, an electron blocking layer 17, a hole injection layer 18, a P-type ohmic contact layer 19, and a P-type electrode 110 stacked from bottom to top. The deep ultraviolet light-emitting diode 100 also includes an N-type electrode 111. A step structure is formed between the current spreading layer 15 and the N-type ohmic contact layer 14, with the N-type electrode 111 placed at the step structure of the N-type ohmic contact layer 14;

The deep ultraviolet light-emitting diode 100 also includes an improvement layer 20 disposed between the N-type ohmic contact layer 14 and the N-type electrode 111. The material of the improvement layer 20 includes at least one of GaN, InN, AIN, AlGaN, InGaN, and AlInGaN.

In this embodiment of the invention, the substrate 11 is a sapphire substrate; sapphire substrates have many advantages: First, the production technology of sapphire substrates is mature and the device quality is good; second, sapphire has very good stability and can be used in high-temperature growth processes; finally, sapphire has high mechanical strength and is easy to process and clean. Therefore, most processes generally use sapphire as the substrate.

In this embodiment of the invention, the intrinsic layer 12 includes a low-temperature buffer layer set on the substrate 11 and an aluminum nitride intrinsic layer set on the low-temperature buffer layer; where the material of the low-temperature buffer layer is aluminum nitride, its growth temperature range is between 400°C and 800°C, and its thickness range is between 10nm and 50nm; the material of the aluminum nitride intrinsic layer 12 is aluminum nitride, its growth temperature range is between 1200°C and 1400°C, and its thickness range is between 500nm and 4000nm.

In this embodiment of the invention, the material of the electron injection layer 13 is N-type doped aluminum gallium nitride material; where the composition range of aluminum element is between 20% and 90%, the thickness range of the electron injection layer 13 is between 500nm and 4000nm, and the growth temperature range of the electron injection layer 13 is between 800°C and 1200°C.

In this embodiment of the invention, the material of the N-type ohmic contact layer 14 is N-type doped aluminum gallium nitride material; where the composition range of aluminum element is between 20% and 90%, the thickness range of the N-type ohmic contact layer 14 is between 500nm and 10000nm, and the growth temperature range of the N-type ohmic contact layer 14 is between 800°C and 1200°C.

In this embodiment of the invention, the current spreading layer 15 is set on the N-type ohmic contact layer 14, and the quantum well active layer 16 is set on the current spreading layer 15; where the growth temperature range of the current spreading layer 15 is between 800°C and 1200°C, and the growth temperature range of the quantum well active layer 16 is between 700°C and 1100°C.

Specifically, the material of the current spreading layer 15 is aluminum gallium nitride, the percentage of aluminum element composition in the current spreading layer 15 ranges from 20% to 90%, and the thickness range of the current spreading layer 15 is between 10nm and 300nm.

Specifically, the barrier thickness range of the quantum well active layer 16 is between 5nm and 30nm, and the percentage of aluminum composition in the barrier ranges from 20% to 100%; the well thickness of the quantum well active layer 16 is between 0.1 and 5nm; and the percentage of aluminum composition in the well ranges from 0 to 80%.

Specifically, a step structure is formed between the current spreading layer 15 and the N-type ohmic contact layer 14, with the N-type electrode 111 placed at the step structure of the N-type ohmic contact layer 14, and the N-type electrode 111 is spaced apart from the current spreading layer 15, where the area of the N-type ohmic contact layer 14 is larger than the area of the current spreading layer 15.

In this embodiment of the invention, the electron blocking layer 17 is set on the quantum well active layer 16, and the growth temperature range of the electron blocking layer 17 is between 700°C and 1100°C; where the electron blocking layer 17 is a single-layer AlGaN structure, the electron blocking layer 17 is a P-type doped semiconductor material, using Mg as the p-type dopant.

Furthermore, the percentage of aluminum element in the electron blocking layer 17 ranges from 50% to 80% of the electron blocking layer 17, and the thickness range of the electron blocking layer 17 is between 0.1nm and 200nm.

In this embodiment of the invention, the hole injection layer 18 is set on the electron blocking layer 17, and the growth temperature range of the hole injection layer 18 is between 700°C and 1100°C; where the material of the hole injection layer 18 is P-type doped aluminum gallium nitride material, the percentage of aluminum composition in the hole injection layer 18 ranges from 0 to 100%, the thickness range of the hole injection layer 18 is between 1nm and 50nm, and the hole injection layer 18 uses magnesium as the P-type dopant.

In this embodiment of the invention, the P-type ohmic contact layer 19 is set on the hole injection layer 18, and the growth temperature range of the P-type ohmic contact layer 19 is between 400°C and 900°C; where the material of the P-type ohmic contact layer 19 is P-type doped gallium nitride material, the thickness range of the P-type ohmic contact layer 19 is between 1nm and 20nm, and the P-type ohmic contact layer 19 uses magnesium element as the P-type dopant.

In this embodiment of the invention, the deep ultraviolet light-emitting diode 100 also includes an improvement layer 20 disposed between the N-type ohmic contact layer 14 and the N-type electrode 111, where the improvement layer 20 is one or more layers of AllnGaN structure introduced by secondary epitaxial growth;
where the material of the improvement layer 20 includes at least one of GaN, InN, AIN, AlGaN, InGaN, and AlInGaN.

In this embodiment of the invention, the percentage range of the orthogonal projection area of the improvement layer 20 on the substrate 11 to the total area of the epitaxial chip of the deep ultraviolet light-emitting diode 100 is between 5% and 95%. When the percentage of the orthogonal projection area of the improvement layer 20 on the substrate 11 to the total area of the epitaxial chip of the deep ultraviolet light-emitting diode 100 is less than 5%, it is difficult to form a good ohmic contact between the N-type electrode 111 and the electron injection layer 13; when the percentage is greater than 95%, it will reduce the light extraction efficiency of the deep ultraviolet light-emitting diode 100.

In this embodiment of the invention, the surface of the improvement layer 20 closer to the substrate 11 is in contact with the N-type ohmic contact layer 14, and the surface of the improvement layer 20 farther from the substrate 11 is in contact with the N-type electrode 111;

Where the N-type ohmic contact layer 14 includes a first ohmic contact part 141 and a second ohmic contact part 142 connected to the first ohmic contact part 141. The orthogonal projection of the improvement layer 20 on the N-type ohmic contact layer 14 coincides with the first ohmic contact part 141. The thickness of the first ohmic contact part 141 is less than or equal to the thickness of the second ohmic contact part 142, and the thickness range of the first ohmic contact part 141 is between 10nm and 5000nm. The purpose of this design is to provide space for secondary epitaxial growth of the improvement layer 20.

Furthermore, the thickness range of the improvement layer 20 is between 20nm and 10000nm; the aluminum composition content of the improvement layer 20 is less than or equal to the aluminum composition content of the electron injection layer 13, this design can improve the injection efficiency of carriers; the dopant of the improvement layer 20 is Si, with a doping concentration range between 1E16cm⁻³ and 1E22cm⁻³.

In this embodiment of the invention, the secondary epitaxial growth temperature of the improvement layer 20 needs to be less than or equal to the growth temperature of the P-type ohmic contact layer 19; this is to reduce the epitaxial growth rate of the improvement layer 20, so that the improvement layer 20 can better fill the first ohmic contact part 141, and reduce the contact resistance of the improvement layer 20.

In this embodiment of the invention, the improvement layer 20 includes any one of the first sub-improvement layer 21, the second sub-improvement layer 22, and the third sub-improvement layer 23.

Specifically, when the improvement layer 20 is the first sub-improvement layer 21, the thickness range of the first sub-improvement layer 21 is between 1nm and 500nm; where the first sub-improvement layer 21 comprises a single-layer structure formed of AlaInbGa1-a-bN material or a composite structure formed of AlₓIn_{y}Ga_{1-x-y}N/AlₘInₙGa₁₋ₘ₋ₙN material, with the values of a, b, x, m, y, and n all being greater than or equal to 0 and less than or equal to 100%.

Furthermore, when the first sub-improvement layer 21 is a single-layer contact improvement structure formed of AlₐIn_{b}Ga_{1-a-b}N material, when a=0% or b=0%, the first sub-improvement layer 21 is a ternary AlGaN or InGaN structure; when both a and b are 0%, the first sub-improvement layer 21 is a binary GaN structure; when a=0% and b=100%, the first sub-improvement layer 21 is an InN structure; when a=100% and b=0%, the first sub-improvement layer 21 is an AIN structure.

Furthermore, when the first sub-improvement layer 21 is a composite contact improvement structure formed of AlₓIn_{y}Ga_{1-x-y}N/AlₘInₙGa₁₋ₘ₋ₙN material, when x, m=0% or y, n=0%, each single layer of the composite contact improvement layer is a ternary AlGaN or InGaN structure; when a and b are both 0%, each single layer of the composite contact improvement layer is a binary GaN structure; when x, m=0% and y, n=100%, each single layer of the composite contact improvement layer is an InN structure; when x, m=100% and y, n=0%, each single layer of the composite contact improvement layer is an AIN structure.

Moreover, the first sub-improvement layer 21 is any one of an N-type doped layer, a P-type doped layer, and an unintentionally doped layer;
where, when the first sub-improvement layer 21 is an N-type doped layer, the dopant is Si, with a doping concentration range between 1E19cm⁻³ and 1E22cm⁻³; when the first sub-improvement layer 21 is a P-type doped layer, the dopant is Mg, with a doping concentration range between 1E18cm⁻³ and 1E23cm⁻³.

In this embodiment of the invention, since the electron injection layer 13 and the N-type ohmic contact layer 14 are usually composed of high Al-content AlGaN, as the Al content in AlGaN increases, Si doping and activation become more difficult, often making it challenging to form a good ohmic contact with the N-type electrode 111, thereby affecting the luminous performance of the deep ultraviolet light-emitting diode 100. Therefore, when the improvement layer 20 is the first sub-improvement layer 21, due to the lower secondary epitaxial growth temperature of the improvement layer 20, it can form a good ohmic contact between the N-type electrode 111 and the electron injection layer 13, thus reducing the operating voltage of the deep ultraviolet light-emitting diode 100, and thereby improving the luminous performance of the epitaxial structure of the deep ultraviolet light-emitting diode 100.

In another embodiment of this invention, the improvement layer 20 is the second sub-improvement layer 22. The second sub-improvement layer 22 includes a multi-layer stacked structure, with the number of layers in the stacked structure of the second sub-improvement layer 22 ranging from 10 to 100. Each layer of the stacked structure includes a first sublayer and a second sublayer stacked from bottom to top. The material of the first sublayer is AlⱼGa₁₋ⱼN, and the material of the second sublayer is AlₖGa₁₋ₖN, with the relationship between j and k satisfying 50%≤j≤k≤100%;

Where the thickness of the first sublayer is 0.25λ*n₁, the thickness of the second sublayer is 0.25λ*n₂, λ is the center wavelength of the light emitted by the quantum well active layer 16, n₁ is the average refractive index of the first sublayer, and n₂ is the average refractive index of the second sublayer.

Specifically, setting the thickness of the first sublayer to 0.25λ*n₁ and the thickness of the second sublayer to 0.25λ*n₂ is to make each sublayer in every layer of the stacked structure a distributed Bragg reflector (DBR). A distributed Bragg reflector is a quarter-wavelength multilayer system, equivalent to a simple set of photonic crystals. Since electromagnetic waves with frequencies falling within the bandgap range cannot penetrate, the reflectivity of the distributed Bragg reflector can reach over 99%, which is beneficial for improving the brightness of the deep ultraviolet light-emitting diode 100. It does not have the absorption problem of metal reflectors and can adjust the bandgap position by changing the refractive index or thickness of the material.

Since most of the emitted light from the quantum well active layer 16 will continuously reflect within the epitaxial chip of the deep ultraviolet light-emitting diode 100, when the direction of the emitted light points towards the N-type electrode 111, the second sub-improvement layer 22 set between the N-type ohmic contact layer 14 and the N-type electrode 111 can further reflect over 99% of the light matching the center wavelength of the emitted light from the quantum well active layer 16, while suppressing stray light that does not match the center wavelength of the emitted light from the quantum well active layer 16. This effectively prevents the emitted light from the quantum well active layer 16 from being absorbed by the N-type electrode 111, thereby effectively improving the external quantum efficiency of the deep ultraviolet light-emitting diode 100.

In this embodiment of the invention, the second sub-improvement layer 22 is any one of an N-type doped layer, a P-type doped layer, and an unintentionally doped layer;

Where, when the second sub-improvement layer 22 is an N-type doped layer, the dopant is Si, with a doping concentration range between 1E19cm⁻³ and 1E22cm⁻³; when the second sub-improvement layer 22 is a P-type doped layer, the dopant is Mg, with a doping concentration range between 1E18cm⁻³ and 1E23cm⁻³.

In this embodiment of the invention, the number of layers in the stacked structure of the second sub-improvement layer 22 ranges from 10 to 100. When the number of layers in the stacked structure of the second sub-improvement layer 22 is less than 10, the effect of the second sub-improvement layer 22 in suppressing stray light that does not match the center wavelength of the emitted light from the quantum well active layer 16 is not very significant; when the number of layers in the stacked structure of the second sub-improvement layer 22 is greater than 100, it will lead to a deterioration in the electron input capability of the deep ultraviolet light-emitting diode 100.

In another embodiment of this invention, the improvement layer 20 is the third sub-improvement layer 23. The third sub-improvement layer 23 includes a single-layer structure formed of N-type doped AlGaN material, with the thickness range of the third sub-improvement layer 23 between 1nm and 500nm;
where the doping concentration of the third sub-improvement layer 23 increases linearly from the side surface of the third sub-improvement layer 23 closer to the substrate 11 towards the side surface of the third sub-improvement layer 23 farther from the substrate 11.

Specifically, the doping concentration range of the side surface of the third sub-improvement layer 23 closer to the substrate 11 is between 1E17cm⁻³ and 1E19cm⁻³, and the doping concentration range of the side surface of the third sub-improvement layer 23 farther from the substrate 11 is between 1E18cm⁻³ and 1E22cm⁻³.

Since the doping concentration affects the emission wavelength of the emitted light, linearly increasing the doping concentration of the third sub-improvement layer 23 from the side surface closer to the substrate 11 towards the side surface farther from the substrate 11 can form an impurity light modulation structure. After being excited by the emitted light from the quantum well active layer 16, the third sub-improvement layer 23 can produce yellow-green light with an emission wavelength between 500nm and 600nm.

In this embodiment of the invention, the third sub-improvement layer 23 is δ-type silicon-doped AlGaN material; where the specific preparation steps for the δ-type silicon-doped AlGaN material are: stop the introduction of MO source during Si doping, and stop the introduction of Si dopant when introducing MO source, with the ratio of MO source to Si dopant introduction time between 10% and 500%. δ-doping can be single or multiple times, with the number not exceeding 50 times.

Specifically, δ-doping is a type of doping different from uniform doping. The δ-doping time is very short, with a deposition thickness of only a few nanometers, much smaller than other film layers. The main function of δ-doping is to adjust the distribution state of impurity concentration, and changes in impurity distribution will affect the semiconductor energy band. δ-doping is mainly pulse doping, primarily performed when gallium source and ammonia are introduced into the reaction chamber without introducing dopants, with doping occurring in pulses. During this process, the gallium source can be stopped to introduce dopants, or dopants can be introduced without stopping the gallium source, with pulses involved throughout the entire process.

Therefore, δ-doping is easier to adjust the distribution state of doping concentration than uniform doping, and δ-doping is easier to dope higher concentrations of dopants than uniform doping.

In this embodiment of the invention, the wavelength range of the first light emitted through the third sub-improvement layer 23 is between 500nm and 600nm, and the wavelength range of the second light emitted through the hole injection layer 18 is between 400nm and 500nm;
where the ratio of the first light to the second light ranges from 10% to 1000%.

Since there is usually impurity light observable to the naked eye in deep ultraviolet light-emitting diodes 100, when the color of the impurity light is non-uniform, it can mislead users in judging the chip's performance. The emitted light from the quantum well active layer 16, on one hand, excites the Mg impurity energy levels in the hole injection layer 18 to emit blue-violet light with a wavelength of 400nm~500nm, and on the other hand, excites the Si impurity energy levels in the electron injection layer 13 to emit yellow-green light with a wavelength of 500nm~600nm. When the ratio between these two differs, the color of the impurity light varies.

Therefore, when the improvement layer 20 is the third sub-improvement layer 23, the electron injection layer 13 will produce yellow-green light with an emission wavelength between 500nm and 600nm, which mixes with the blue-violet light with a wavelength between 400nm and 500nm excited from the hole injection layer 18. The third sub-improvement layer 23 is used to modulate the wavelength of the first light produced by the electron injection layer 13, so that the yellow-green stray light produced by the electron injection layer 13 mixes with the blue-violet stray light produced by the hole injection layer 18 in a certain proportion (the ratio of yellow-green impurity light to blue-violet impurity light is 10%~1000%), forming blue-violet, yellowish-green, or white impurity light, thereby improving the emission uniformity of the deep ultraviolet light-emitting diode.

Unlike existing technology, this embodiment of the invention achieves the following through secondary epitaxial growth of a special epitaxial structure as an improvement layer 20 between the N-type ohmic contact layer 14 and the N-type electrode 111, with the material of the improvement layer 20 including at least one of GaN, InN, AIN, AlGaN, InGaN, and AllnGaN: When the improvement layer 20 is the first sub-improvement layer 21 , it enables the formation of a good ohmic contact between the N-type electrode 111 and the electron injection layer 13, thereby reducing the operating voltage of the deep ultraviolet light-emitting diode 100 and improving the luminous performance of its epitaxial structure; When the improvement layer 20 is the second sub-improvement layer 22, set between the N-type ohmic contact layer 14 and the N-type electrode 111, it can further reflect over 99% of the light matching the center wavelength of the emitted light from the quantum well active layer 16, while suppressing stray light that does not match the center wavelength, thus preventing the emitted light from the quantum well active layer 16 from being absorbed by the N-type electrode 111 and effectively improving the external quantum efficiency of the deep ultraviolet light-emitting diode 100; When the improvement layer 20 is the third sub-improvement layer 23, it is used to modulate the wavelength of the first light produced by the electron injection layer 13, so that the yellow-green stray light produced by the electron injection layer 13 mixes with the blue-violet stray light produced by the hole injection layer 18 in a certain proportion, forming blue-violet, yellowish-green, or white impurity light, thereby improving the emission uniformity of the deep ultraviolet light-emitting diode.

### Embodiment 2

Please refer to Figure 2, which is the second structural diagram of the deep ultraviolet light-emitting diode 100 provided in this embodiment of the invention; where the structure of the deep ultraviolet light-emitting diode 100 provided in this embodiment is the same or similar to that provided in Embodiment 1, with the only difference being that the improvement layer 20 includes a composite layer formed by any two of the first sub-improvement layer 21, the second sub-improvement layer 22, and the third sub-improvement layer 23;

In the first scheme of this embodiment, the improvement layer 20 includes the second sub-improvement layer 22 and the first sub-improvement layer 21 stacked from bottom to top; The improvement layer 20 prepared by this scheme can not only reduce the operating voltage of the deep ultraviolet light-emitting diode 100 through the first sub-improvement layer 21, but also improve the external quantum efficiency of the deep ultraviolet light-emitting diode 100 through the second sub-improvement layer 22, thereby enhancing the luminous performance of the deep ultraviolet light-emitting diode 100.

In the second scheme of this embodiment, the improvement layer 20 includes the third sub-improvement layer 23 and the first sub-improvement layer 21 stacked from bottom to top; The improvement layer 20 prepared by this scheme can not only improve the emission uniformity of the deep ultraviolet light-emitting diode 100 through the third sub-improvement layer 23, but also reduce the operating voltage of the deep ultraviolet light-emitting diode 100 through the first sub-improvement layer 21, thereby enhancing the luminous performance of the deep ultraviolet light-emitting diode 100.

In the third scheme of this embodiment, the improvement layer 20 includes the third sub-improvement layer 23 and the second sub-improvement layer 22 stacked from bottom to top; The improvement layer 20 prepared by this scheme can not only improve the emission uniformity of the deep ultraviolet light-emitting diode 100 through the third sub-improvement layer 23, but also enhance the external quantum efficiency of the deep ultraviolet light-emitting diode 100 through the second sub-improvement layer 22, thereby improving the luminous performance of the deep ultraviolet light-emitting diode 100.

### Embodiment 3

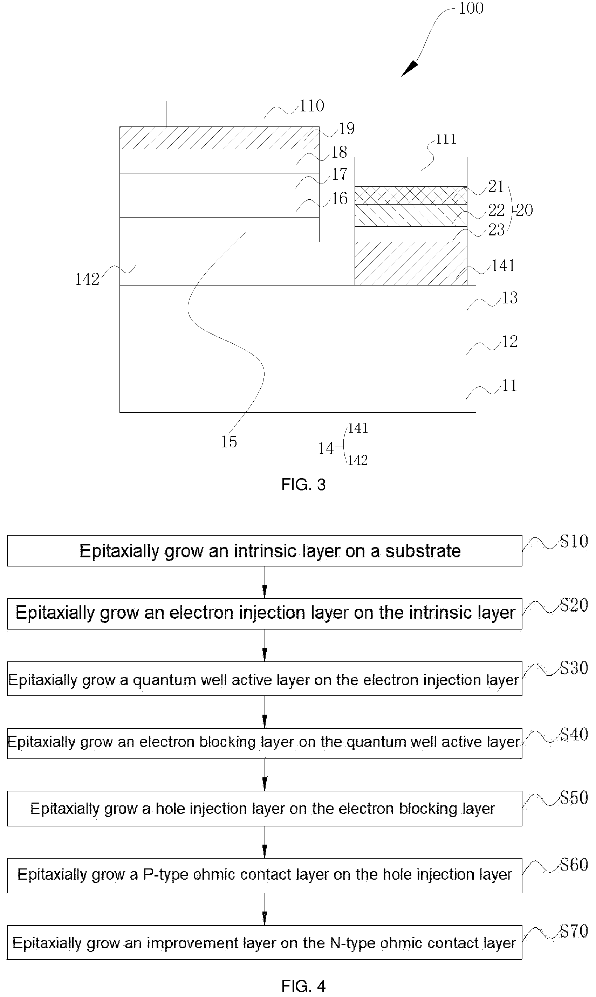

Please refer to Figure 3, which is the third structural diagram of the deep ultraviolet light-emitting diode 100 provided in this embodiment of the invention; where the structure of the deep ultraviolet light-emitting diode 100 provided in Embodiment 3 is the same or similar to that provided in Embodiment 2, with the only difference being that the improvement layer 20 includes the third sub-improvement layer 23, the second sub-improvement layer 22, and the first sub-improvement layer 21 stacked from bottom to top.

The improvement layer 20 prepared by this scheme can not only improve the emission uniformity of the deep ultraviolet light-emitting diode 100 through the third sub-improvement layer 23, but also enhance the external quantum efficiency of the deep ultraviolet light-emitting diode 100 through the second sub-improvement layer 22, and reduce the operating voltage of the deep ultraviolet light-emitting diode 100 through the first sub-improvement layer 21, thereby improving the luminous performance of the deep ultraviolet light-emitting diode 100.

Therefore, the deep ultraviolet light-emitting diode 100 prepared in Embodiment 3 of this invention has better luminous performance compared to Embodiment 1 or Embodiment 2 of this invention.

Correspondingly, this embodiment of the invention also provides an epitaxial growth method for a deep ultraviolet light-emitting diode 100; Please refer to Figure 4, which is the process flow diagram of the epitaxial growth method for the deep ultraviolet light-emitting diode 100 provided in this embodiment of the invention. Specifically, taking the preparation of Embodiment 3 of this invention as an example, the epitaxial growth method includes:
S10, Epitaxially grow an intrinsic layer 12 on a substrate 11.

Specifically, S10 also includes:
First, provide a substrate 11, which is a sapphire substrate 11; then, at 400°C~800°C, grow a low-temperature buffer layer on the substrate 11, with the thickness range of the buffer layer between 10nm and 50nm; finally, raise the growth temperature to between 1200°C and 1400°C, and grow an aluminum nitride intrinsic layer 12 on the buffer layer, with the thickness range of the aluminum nitride intrinsic layer 12 between 500nm and 4000nm. The buffer layer and the aluminum nitride intrinsic layer 12 constitute the intrinsic layer 12, and the material of both the buffer layer and the aluminum nitride intrinsic layer 12 is aluminum nitride.

S20, Epitaxially grow an electron injection layer 13 on the intrinsic layer 12.

Specifically, S20 also includes:
First, lower the growth temperature to between 800°C and 1200°C; then, epitaxially grow the electron injection layer 13 on the intrinsic layer 12. The material of the electron injection layer 13 is N-type doped aluminum gallium nitride material; where the composition range of aluminum element is between 20% and 90%.

S30, Epitaxially grow a quantum well active layer 16 on the electron injection layer 13.

Specifically, S30 also includes:
First, maintain the growth temperature range between 800°C and 1200°C, epitaxially grow an N-type ohmic contact layer 14 on the electron injection layer 13, where the material of the N-type ohmic contact layer 14 is N-type doped aluminum gallium nitride material, with the composition range of aluminum element between 20% and 90%.

Then, maintain the growth temperature range unchanged between 800°C and 1200°C, epitaxially grow a current spreading layer 15 on the N-type ohmic contact layer 14; specifically, the material of the current spreading layer 15 is aluminum gallium nitride, the percentage of aluminum element composition in the current spreading layer 15 ranges from 20% to 90%, and the thickness range of the current spreading layer 15 is between 10nm and 300nm.

A step structure is formed between the N-type ohmic contact layer 14 and the current spreading layer 15, and the area of the N-type ohmic contact layer 14 is larger than the area of the current spreading layer 15.

Then, lower the growth temperature to between 700°C and 1100°C, epitaxially grow the quantum well active layer 16 on the current spreading layer 15; where the barrier thickness range of the quantum well active layer 16 is between 5 and 30nm, and the percentage of aluminum composition in the barrier ranges from 20% to 100%; the well thickness of the quantum well active layer 16 is between 0.1 and 5nm; and the percentage of aluminum composition in the well ranges from 0 to 80%.

S40, Epitaxially grow an electron blocking layer 17 on the quantum well active layer 16.

Specifically, S40 also includes:
First, maintain the growth temperature range between 700°C and 1100°C, epitaxially grow the electron blocking layer 17 on the quantum well active layer 16; where the electron blocking layer 17 is a single-layer AlGaN structure, the electron blocking layer 17 is a P-type doped semiconductor material, using Mg as the p-type dopant.

Furthermore, the percentage of aluminum element in the electron blocking layer 17 ranges from 50% to 80% of the electron blocking layer 17, and the thickness range of the electron blocking layer 17 is between 0.1nm and 200nm.

S50, Epitaxially grow a hole injection layer 18 on the electron blocking layer 17.

Specifically, S50 also includes:
Maintain the growth temperature between 700°C and 1100°C, epitaxially grow the hole injection layer 18 on the electron blocking layer 17. Where the material of the hole injection layer 18 is P-type doped aluminum gallium nitride material, the percentage of aluminum composition in the hole injection layer 18 ranges from 0 to 100%, the thickness range of the hole injection layer 18 is between 1nm and 50nm, and the hole injection layer 18 uses magnesium element as the P-type dopant.

S60, Epitaxially grow a P-type ohmic contact layer 19 on the hole injection layer 18.

Specifically, S60 also includes:
First, lower the growth temperature to between 400°C and 900°C, form the P-type ohmic contact layer 19 on the hole injection layer 18; where the material of the P-type ohmic contact layer 19 is P-type doped gallium nitride material, the thickness range of the P-type ohmic contact layer 19 is between 1nm and 20nm, and the P-type ohmic contact layer 19 uses magnesium element as the P-type dopant.

S70, Epitaxially grow an improvement layer 20 on the N-type ohmic contact layer 14.

Specifically, S70 also includes:
First, perform MESA etching on the step structure of the N-type ohmic contact layer 14; then, lower the growth temperature in the reaction chamber, perform secondary epitaxial growth of the improvement layer 20 on the N-type ohmic contact layer 14 corresponding to the MESA etched position, where the improvement layer 20 includes the third sub-improvement layer 23, the second sub-improvement layer 22, and the first sub-improvement layer 21 stacked from bottom to top.

Finally, place the N-type electrode 111 on the improvement layer 20, with the N-type electrode 111 positioned opposite to and spaced apart from the current spreading layer 15; lastly, form the P-type electrode 110 on the P-type ohmic contact layer 19.

Specifically, six different types of deep ultraviolet light-emitting diodes 100 were prepared according to the above epitaxial growth method for the deep ultraviolet light-emitting diode 100. After the preparation of these deep ultraviolet light-emitting diodes 100 was completed, their working voltage, light output efficiency, and impurity light color were tested under a working current of 40mA.

Furthermore, the film layer structures of the above six different types of deep ultraviolet light-emitting diodes 100 are roughly the same from the substrate 11 to the P-type ohmic contact layer 19, stacked from bottom to top as follows:
Substrate 11, material is sapphire substrate;
Intrinsic layer 12, material is aluminum nitride, thickness is 1000nm;
Electron injection layer 13 is N-type doped aluminum gallium nitride material, where the Al composition accounts for 50% of the mass percentage of the electron injection layer 13, thickness is 1000nm;
N-type ohmic contact layer 14 is N-type doped aluminum gallium nitride material, where the Al composition accounts for 50% of the mass percentage of the electron injection layer 13, thickness is 1000nm;
Current spreading layer 15 material is unintentionally doped aluminum gallium nitride material, where the mass percentage of aluminum composition in the current spreading layer 15 is 70%, thickness is 100nm;
The quantum well thickness of the quantum well active layer 16 is 5nm and the mass percentage of aluminum composition in the quantum well is 50%, the barrier thickness is 2nm and the mass percentage of aluminum composition in the barrier is 60%;
Electron blocking layer 17 is a single-layer aluminum gallium nitride structure, thickness is 10nm, mass percentage of aluminum composition is 60%;
Hole injection layer 18 material is P-type doped aluminum gallium nitride material, the mass percentage of aluminum composition in the hole injection layer 18 is 40%, thickness is 20nm, using Mg as the dopant;
P-type ohmic contact layer 19 is metal-polar aluminum gallium nitride material doped only with magnesium, thickness is 5nm.

In the above six types of deep ultraviolet light-emitting diodes 100, N-type electrodes 111 of the same material are set on the electron injection layer 13 using conventional methods, and P-type electrodes 110 of the same material are set on the P-type ohmic contact layer 19, to form a complete epitaxial chip structure. The specific process will not be elaborated here. Both the N-type electrode 111 and the P-type electrode 110 are multi-layer composite metal materials.

In this embodiment of the invention, the only difference in the preparation methods of the above six different types of deep ultraviolet light-emitting diodes 100 is: The film layer structure between the N-type ohmic contact layer 14 and the N-type electrode 111 is different, specifically as follows:

### Example 1:

The epitaxial structure of the first embodiment deep ultraviolet light-emitting diode 100 (deep ultraviolet LED1) of this application has an improvement layer 20 set between the N-type ohmic contact layer 14 and the N-type electrode 111. The improvement layer 20 is a first sub-improvement layer 21 with a secondary epitaxial low-temperature contact improvement structure, specifically a single-layer structure of Si-doped GaN material, where the Si doping concentration is 1E19cm-3 and the thickness is 10nm.

### Example 2:

The epitaxial structure of the second embodiment deep ultraviolet light-emitting diode 100 (deep ultraviolet LED3) of this application has an improvement layer 20 set between the N-type ohmic contact layer 14 and the N-type electrode 111. The improvement layer 20 is a second sub-improvement layer 22 with a secondary epitaxial Bragg reflection structure, with a thickness of 10nm;
Where the second sub-improvement layer 22 includes a multi-layer stacked structure, the number of layers in the stacked structure of the second sub-improvement layer 22 is 30, each layer of the stacked structure includes a first sublayer and a second sublayer stacked from bottom to top, the material of the first sublayer is AIN, and the material of the second sublayer is GaN;
Where the thickness of the first sublayer is 0.25λ*n₁, the thickness of the second sublayer is 0.25λ*n₂, λ is the center wavelength of the light emitted by the quantum well active layer 16, n₁ is the average refractive index of the first sublayer, and n₂ is the average refractive index of the second sublayer.

### Example 3:

The epitaxial structure of the third embodiment deep ultraviolet light-emitting diode 100 (deep ultraviolet LED3) of this application has an improvement layer 20 set between the N-type ohmic contact layer 14 and the N-type electrode 111. The improvement layer 20 is a third sub-improvement layer 23 with a secondary epitaxial light adjustment improvement structure;
Where the third sub-improvement layer 23 includes a single-layer structure formed of Si-doped AlGaN material, and the thickness of the third sub-improvement layer 23 is 10nm;
Where the doping concentration of the third sub-improvement layer 23 increases linearly from the side surface of the third sub-improvement layer 23 closer to the substrate 11 towards the side surface of the third sub-improvement layer 23 farther from the substrate 11.

Specifically, the doping concentration of the side surface of the third sub-improvement layer 23 closer to the substrate 11 is 1E17cm⁻³, and the doping concentration of the side surface of the third sub-improvement layer 23 farther from the substrate 11 is 1E20cm⁻³.

### Example 4:

The epitaxial structure of the fourth embodiment deep ultraviolet light-emitting diode 100 (deep ultraviolet LED4) of this application has an improvement layer 20 set between the N-type ohmic contact layer 14 and the N-type electrode 111. The improvement layer 20 includes the second sub-improvement layer 22 and the first sub-improvement layer 21 stacked from bottom to top;
Specifically, the second sub-improvement layer 22 includes a multi-layer stacked structure, with a thickness of 10nm; the number of layers in the stacked structure of the second sub-improvement layer 22 is 30, each layer of the stacked structure includes a first sublayer and a second sublayer stacked from bottom to top, the material of the first sublayer is AIN, and the material of the second sublayer is GaN;
Where the thickness of the first sublayer is 0.25λ*n₁, the thickness of the second sublayer is 0.25λ*n₂, λ is the center wavelength of the light emitted by the quantum well active layer 16, n₁ is the average refractive index of the first sublayer, and n₂ is the average refractive index of the second sublayer.

Specifically, the first sub-improvement layer 21 is a single-layer structure of Si-doped GaN material, where the Si doping concentration is 1E19cm⁻³ and the thickness is 10nm.

### Example 5:

The epitaxial structure of the fifth embodiment deep ultraviolet light-emitting diode 100 (deep ultraviolet LED5) of this application has an improvement layer 20 set between the N-type ohmic contact layer 14 and the N-type electrode 111. The improvement layer 20 includes the third sub-improvement layer 23, the second sub-improvement layer 22, and the first sub-improvement layer 21 stacked from bottom to top;
Specifically, the third sub-improvement layer 23 includes a single-layer structure formed of Si-doped AlGaN material, and the thickness of the third sub-improvement layer 23 is 10nm;
Where the doping concentration of the third sub-improvement layer 23 increases linearly from the side surface of the third sub-improvement layer 23 closer to the substrate 11 towards the side surface of the third sub-improvement layer 23 farther from the substrate 11. The doping concentration of the side surface of the third sub-improvement layer 23 closer to the substrate 11 is 1E17cm⁻³, and the doping concentration of the side surface of the third sub-improvement layer 23 farther from the substrate 11 is 1E20cm⁻³.

Specifically, the second sub-improvement layer 22 includes a multi-layer stacked structure, with a thickness of 10nm; the number of layers in the stacked structure of the second sub-improvement layer 22 is 30, each layer of the stacked structure includes a first sublayer and a second sublayer stacked from bottom to top, the material of the first sublayer is AIN, and the material of the second sublayer is GaN;
Where the thickness of the first sublayer is 0.25λ*n₁, the thickness of the second sublayer is 0.25λ*n₂, λ is the center wavelength of the light emitted by the quantum well active layer 16, n₁ is the average refractive index of the first sublayer, and n₂ is the average refractive index of the second sublayer.

Specifically, the first sub-improvement layer 21 is a single-layer structure of Si-doped GaN material, where the Si doping concentration is 1E19cm⁻³ and the thickness is 10nm.

### Comparative Example:

The epitaxial structure of the comparative example deep ultraviolet light-emitting diode 100 (deep ultraviolet LED6) of this application has no improvement layer 20 set between the N-type ohmic contact layer 14 and the N-type electrode 111, and it is prepared using conventional epitaxial growth methods.

Finally, the working voltage, light output efficiency, and impurity light color of the above six types of deep ultraviolet light-emitting diodes 100 were tested under a driving current of 40mA. The experimental results are shown in the following Table 1:

**Table 1**

| Sample | Voltage (V) | Optical Power (mW) | Impurity Light Color |
|---|---|---|---|
| Example 1 | 5.4 | 7.3 | Blue |
| Example 2 | 6.3 | 8.6 | Blue |
| Example 3 | 6.1 | 7.1 | White |
| Example 4 | 5.6 | 8.4 | Blue |
| Example 5 | 5.7 | 8.5 | White |
| Comparative Example | 6 | 7.2 | Blue |

From the above Table 1, comparing Examples 1, 4, and 5 with the Comparative Example, it can be seen that setting the first sub-improvement layer 21 between the N-type ohmic contact layer 14 and the N-type electrode 111 results in a lower working voltage compared to the deep ultraviolet light-emitting diode 100 prepared by conventional methods.

Furthermore, comparing Examples 2, 4, and 5 with the Comparative Example, it can be seen that setting the second sub-improvement layer 22 between the N-type ohmic contact layer 14 and the N-type electrode 111 results in higher light output efficiency compared to the deep ultraviolet light-emitting diode 100 prepared by conventional methods.

Furthermore, comparing Examples 3 and 5 with the Comparative Example, it can be seen that setting the third sub-improvement layer 23 between the N-type ohmic contact layer 14 and the N-type electrode 111 results in better light emission uniformity compared to the deep ultraviolet light-emitting diode 100 prepared by conventional methods.

Furthermore, comparing Example 4 with the Comparative Example, it is known that setting both the second sub-improvement layer 22 and the first sub-improvement layer 21 between the N-type ohmic contact layer 14 and the N-type electrode 111 results in a deep ultraviolet light-emitting diode 100 that has a lower operating voltage and higher light output efficiency compared to those prepared by conventional methods.

Furthermore, comparing Example 5 with the Comparative Example, it is known that setting the third sub-improvement layer 23, the second sub-improvement layer 22, and the first sub-improvement layer 21 between the N-type ohmic contact layer 14 and the N-type electrode 111 results in a deep ultraviolet light-emitting diode 100 that has a lower operating voltage, higher light output efficiency, and better light uniformity compared to those prepared by conventional methods.

In summary, unlike existing technology, the embodiments of this invention provide a deep ultraviolet light-emitting diode 100, comprising a substrate 11, an intrinsic layer 12, an electron injection layer 13, an N-type ohmic contact layer 14, a current spreading layer 15, a quantum well active layer 16, an electron blocking layer 17, a hole injection layer 18, a P-type ohmic contact layer 19, and a P-type electrode 110 stacked from bottom to top. The deep ultraviolet light-emitting diode 100 also includes an N-type electrode 111. A step structure is formed between the current spreading layer 15 and the N-type ohmic contact layer 14, with the N-type electrode 111 placed at the step structure of the N-type ohmic contact layer 14. Additionally, the deep ultraviolet light-emitting diode 100 includes an improvement layer 20 disposed between the N-type ohmic contact layer 14 and the N-type electrode 111. The material of the improvement layer 20 includes at least one of GaN, InN, AIN, AlGaN, InGaN, and AlInGaN. By epitaxially growing a special epitaxial structure as an improvement layer 20 between the N-type ohmic contact layer 14 and the N-type electrode 111, and with the material of the improvement layer 20 including at least one of GaN, InN, AIN, AlGaN, InGaN, and AllnGaN, a good ohmic contact is formed between the N-type electrode 111 and the electron injection layer 13, thereby reducing the operating voltage of the deep ultraviolet light-emitting diode 100 and improving the luminous performance of its epitaxial structure.

It should be noted that all the above examples belong to the same inventive concept, and each example is described with a focus on different aspects. For details not thoroughly described in one example, reference can be made to the descriptions in other examples.

The above embodiments only express the implementation methods of this invention. Their descriptions are relatively specific and detailed, but this should not be understood as a limitation on the scope of the patent for this invention. It should be pointed out that for ordinary technicians in this field, without departing from the concept of this invention, several modifications and improvements can still be made, all of which belong to the protection scope of this invention. Therefore, the protection scope of this invention patent should be based on the attached claims.

## Claims

1. A deep ultraviolet light-emitting diode, **characterized by** comprising:
a substrate, an intrinsic layer, an electron injection layer, an N-type ohmic contact layer, a current spreading layer, a quantum well active layer, an electron blocking layer, a hole injection layer, a P-type ohmic contact layer, and a P-type electrode stacked from bottom to top. The deep ultraviolet light-emitting diode also includes an N-type electrode. A step structure is formed between the current spreading layer and the N-type ohmic contact layer, with the N-type electrode placed at the step structure of the N-type ohmic contact layer;
the deep ultraviolet light-emitting diode also includes an improvement layer disposed between the N-type ohmic contact layer and the N-type electrode. The material of the improvement layer includes at least one of GaN, InN, AIN, AlGaN, InGaN, and AllnGaN.

2. The deep ultraviolet light-emitting diode according to claim 1, **characterized in that** the thickness of the improvement layer ranges from 20nm to 10000nm; the aluminum composition content of the improvement layer is less than or equal to the aluminum composition content of the electron injection layer; the dopant of the improvement layer is Si, with a doping concentration range between 1E16cm⁻³ and 1E22cm⁻³.

3. The deep ultraviolet light-emitting diode according to claim 1, **characterized in that** the improvement layer includes a first sub-improvement layer, the first sub-improvement layer comprising a single-layer structure formed of AlaInbGa1-a-bN material or a composite structure formed of AlₓIn_{y}Ga_{1-x-y}N/AlₘInₙGa₁₋ₘ₋ₙN material;
where the values of a, b, x, m, y, and n are all greater than or equal to 0 and less than or equal to 100%.

4. The deep ultraviolet light-emitting diode according to claim 3, **characterized in that** the first sub-improvement layer is any one of an N-type doped layer, a P-type doped layer, and an unintentionally doped layer;
when the first sub-improvement layer is an N-type doped layer, the dopant is Si, with a doping concentration range between 1E19cm-3 and 1E22cm-3; when the first sub-improvement layer is a P-type doped layer, the dopant is Mg, with a doping concentration range between 1E18cm⁻³ and 1E23cm⁻³.

5. The deep ultraviolet light-emitting diode according to claim 1, **characterized in that** the improvement layer includes a second sub-improvement layer, the second sub-improvement layer comprising a multi-layer stacked structure, each layer of the stacked structure including a first sublayer and a second sublayer stacked from bottom to top, the material of the first sublayer being AljGa1-jN, the material of the second sublayer being AlkGa1-kN, with the relationship between j and k satisfying 50%≤j≤k≤100%;
where the thickness of the first sublayer is 0.25λ*n₁, the thickness of the second sublayer is 0.25λ*n₂, λ is the center wavelength of the light emitted by the quantum well active layer, n₁ is the average refractive index of the first sublayer, and n₂ is the average refractive index of the second sublayer.

6. The deep ultraviolet light-emitting diode according to claim 5, **characterized in that** the second sub-improvement layer is any one of an N-type doped layer, a P-type doped layer, and an unintentionally doped layer;
where, when the second sub-improvement layer is an N-type doped layer, the dopant is Si, with a doping concentration range between 1E19cm⁻³ and 1E22cm⁻³; when the second sub-improvement layer is a P-type doped layer, the dopant is Mg, with a doping concentration range between 1E18cm⁻³ and 1E23cm⁻³.

7. The deep ultraviolet light-emitting diode according to claim 1, **characterized in that** the improvement layer includes a third sub-improvement layer, the third sub-improvement layer comprising a single-layer structure formed of N-type doped AlGaN material;
where the doping concentration of the third sub-improvement layer increases linearly from the side surface of the third sub-improvement layer closer to the substrate towards the side surface of the third sub-improvement layer farther from the substrate.

8. The deep ultraviolet light-emitting diode according to claim 7, **characterized in that** the third sub-improvement layer is δ-type silicon-doped AlGaN material;
where the number of δ-type silicon doping ranges from 1 to 50.

9. The deep ultraviolet light-emitting diode according to claim 7, **characterized in that** the wavelength range of the first light emitted through the electron injection layer is between 500nm and 600nm, and the wavelength range of the second light emitted through the hole injection layer is between 400nm and 500nm;
where the ratio of the first light to the second light ranges from 10% to 1000%.

10. The deep ultraviolet light-emitting diode according to claim 1, **characterized in that** the improvement layer includes at least two of the first sub-improvement layer, the second sub-improvement layer, and the third sub-improvement layer;
where the first sub-improvement layer comprises a single-layer structure formed of AlalnbGa1-a-bN material or a composite structure formed of AlₓIn_{y}Ga_{1-x-y}N/AlₘInₙGa₁₋ₘ₋ₙN material, with the values of a, b, x, m, y, and n all being greater than or equal to 0 and less than or equal to 100%;
the second sub-improvement layer includes a multi-layer stacked structure, each layer of the stacked structure including a first sublayer and a second sublayer stacked from bottom to top, the material of the first sublayer being AljGa1-jN, the material of the second sublayer being AlkGa1-kN, with the relationship between j and k satisfying 50%≤j≤k≤100%, where the thickness of the first sublayer is 0.25λ*n₁, the thickness of the second sublayer is 0.25λ*n₂, λ is the center wavelength of the light emitted by the quantum well active layer, n₁ is the average refractive index of the first sublayer, and n₂ is the average refractive index of the second sublayer;
the third sub-improvement layer includes a single-layer structure formed of N-type doped AlGaN material, where the doping concentration of the third sub-improvement layer increases linearly from the side surface of the third sub-improvement layer closer to the substrate towards the side surface of the third sub-improvement layer farther from the substrate.
